# EUROPEAN PATENT SPECIFICATION

(11) **EP 3 823 030 B1**
(45) Date of publication and mention of the grant of the patent: **10.05.2023**
(21) Application number: 19833754.5
(22) Date of filing: 24.06.2019
(51) Int. Cl.: H01L 27/15, H01L 33/38, H01L 33/62, H01L 33/54, H01L 33/56, H01L 25/075

(54) **METHOD FOR MANUFACTURING A MICRO-LED DISPLAY**
HERSTELLUNGSVERFAHREN EINER MIKRO-LED-ANZEIGE
PROCÉDÉ DE FABRICATION D'UN DISPOSITIF D'AFFICHAGE À MICRO-DEL

(30) Priority: 13.07.2018 KR 20180081682
(43) Date of publication of application: 19.05.2021
(73) Proprietor: Samsung Electronics Co., Ltd., Suwon-si 16677 (KR)
(72) Inventor: KOO, Jamyeong, Suwon-si Gyeonggi-do 16677 (KR); JO, Youngkyong, Suwon-si Gyeonggi-do 16677 (KR); LEE, Byunghoon, Suwon-si Gyeonggi-do 16677 (KR)
(74) Representative: Arnold & Siedsma
(86) International application number: PCT/KR2019/007564
(87) International publication number: WO 2020/013478

(56) References cited:
- KR-A- 20160 091 526
- KR-A- 20180 075 856
- KR-B1- 100 638 824
- KR-B1- 101 754 528
- US-A1- 2007 048 891
- US-A1- 2016 218 289
- US-A1- 2017 263 593
- US-A1- 2017 263 593
- US-A1- 2017 294 424
- US-A1- 2017 365 588

## Description

### Technical Field

Various embodiments of the disclosure relate to a multi-transfer technology of a micro-LED chip.

### Background Art

There is technology for making, as a new display, a display panel by mounting LEDs emitting R (red), G (green), and B (blue) colors on a circuit board.

However, in order to implement a display, the development of a micro-LEDs (µLEDs) that are capable of corresponding to current pixels must be preceded. Further, it is necessary to solve in advance the problem of how to pick up micro-LED chips of several tens of µm in size and place the chips on a circuit board precisely, and the problem of how to arrange input/output terminals and electrically connect the terminals to a main printed circuit board.

Conventionally, a method using a dedicated chip-bonding device has been performed, in which a LED chip is picked up by vacuum suction using a finely processed nozzle and is then put down to be in one-to-one correspondence with a desired electrode on a circuit board, and then the nozzle moves away therefrom.

US 2017/365588 A1 discloses an optoelectronic semiconductor device that includes an epitaxial substrate and a plurality of microsized optoelectronic semiconductor elements. The microsized optoelectronic semiconductor elements are disposed separately and disposed on a surface of the epitaxial substrate. A length of a side of each of the microsized optoelectronic semiconductor elements is between 1 micrometer and 100 micrometers, and a minimum interval between two adjacent microsized optoelectronic semiconductor elements is 1 micrometer.

US 2017/263593 A1 discloses another conventional transfer method.

### Disclosure of Invention

### Technical Problem

However, the conventional method in which one nozzle picks up and places one individual chip has problems in that it takes a lot of time to mount a plurality of LED chips on a board at high speed, and that price increases and equipment is complicated due to installation of a number of nozzle units.

In addition, due to the limitation of nozzle processing, there is a technical limitation in transferring micro-LEDs of 100 microns or less.

According to various embodiments of the disclosure, it is possible to provide a method of manufacturing a micro-LED display with a high-speed transfer method.

According to various embodiments of the disclosure, it is possible to provide a manufacturing method, in which a composite resin layer having an adhesive property that absorbs an impact applied from a micro-LED chip due to an impact of gas plumes generated during ablation is used, whereby transfer yield is improved.

According to various embodiments of the disclosure, it is possible to provide a method of manufacturing a micro-LED display, in which in order to improve the precision in seating position of a micro-LED chip, a composite agent composed of a flux and an epoxy (or acrylic) adhesive is coated on a target board to which the micro-LED chip is transferred so as to reduce an impact applied when the micro-LED chip falls down, whereby a transfer yield is improved.

According to various embodiments of the disclosure, it is possible to provide a method of manufacturing a micro-LED display, in which the shape of electrodes of a circuit board is changed in order to minimize occurrence of defects due to misalignment of a micro-LED chip in the X and Y direction or in particular, due to tilting of the micro-LED chip during the transfer of the micro-LED chip.

### Solution to Problem

According to the disclosure, a micro-LED display may include: a circuit board; at least one first electrode provided on the circuit board; at least one micro-LED chip bonded onto the first electrode; a second electrode provided on the micro-LED chip; a bonding structure formed by heating the first electrode and the second electrode through laser irradiation; and at least one composite resin part supporting the bonding structure.

According to an embodiment of the invention, a method of manufacturing a micro-LED display includes: a first step for forming a composite resin layer on a circuit board; a second step for aligning a transparent board to which a plurality of micro-LED chips are attached via adhesive on the first board; a third step of ablating the adhesive by irradiating each of the micro-LED chips with at least one first laser beam; a fourth step of jetting the micro-LED chips to be seated on the composite resin layer; a fifth step of irradiating electrodes of the seated micro-LED chips with at least one second laser beam; and a sixth step of bonding electrodes of the circuit board and the electrodes of the micro LED chips by means of said irradiating with the at least one second laser beam.

### Advantageous Effects of Invention

The disclosure enables multi-transfer of micro LED chips using a LASER ablation method at high speed, thereby improving productivity.

In addition, the disclosure is capable of improving the transfer yield of micro LED chips.

### Brief Description of Drawings

FIG. 1A is a view illustrating the configuration of a base board for manufacturing micro-LED chips in a pad-up state according to various embodiments of the disclosure.
FIG. 1B is a view illustrating the configuration of a base board for manufacturing micro-LED chips in a pad-down state according to various embodiments of the disclosure.
FIG. 1C is a view illustrating a configuration of a micro-LED chip according to various embodiments of the disclosure.
FIG. 2A is a plan view illustrating the state in which micro-LED chips are attached to a transparent board according to various embodiments of the disclosure, and FIG. 2B is a side view illustrating the state in which micro-LED chips are attached to a transparent board according to various embodiments of the disclosure.
FIG. 3 is a cross-sectional view illustrating the structure of a micro-LED display according to various embodiments of the disclosure.
FIG. 4 is a flowchart sequentially illustrating a process of manufacturing a micro-LED display according to various embodiments of the disclosure.
FIGS. 5A to 5D are cross-sectional views sequentially illustrating a process of manufacturing a micro-LED display according to various embodiments of the disclosure.
FIG. 6A is a plan view illustrating the state in which a micro-LED chip according to various embodiments of the disclosure is connected to first electrodes, and FIG. 6B is a vertical cross-sectional view illustrating the state in which a micro-LED chip according to various embodiments of the disclosure is connected to first electrodes.
FIG. 7A is a plan view illustrating the state in which a micro-LED chip according to various embodiments of the disclosure is connected to first electrodes.
FIG. 7B is a plan view illustrating the state in which a micro-LED chip according to various embodiments of the disclosure is incorrectly connected to first electrodes.
FIG. 8 is a plan view illustrating a shape of first electrodes according to various embodiments of the disclosure.
FIG. 9 is a plan view illustrating another shape of first electrodes according to various embodiments of the disclosure.
FIG. 10 is a plan view illustrating a micro-LED display manufactured according to various embodiments of the disclosure.

### Best Mode for Carrying out the Invention

Hereinafter, various embodiments of the disclosure will be described with reference to the accompanying drawings. However, it shall be understood that it is not intended to limit the disclosure to specific embodiments, and that the disclosure includes various modifications, equivalents, and/or alternatives of embodiments of the disclosure. In connection with the description of drawings, similar components may be denoted by similar reference numerals.

Hereinafter, with reference to the accompanying drawings, a structure of a display and a method of manufacturing the display using a micro-LED mounting technology according to various embodiments of the disclosure will be described. It is to be understood that the present invention relates to a manufacturing method. The described micro-LED chips, micro-LED displays, and intermediate structures obtained at different stages of the manufacturing method, are useful to understand the invention but do not form part of the invention per se, even when they are referred to as "embodiments".

Since the configuration of the display according to an exemplary embodiment of the disclosure is capable of being implemented regardless of the size of an LED, the size of a used LED is not limited. For example, a lighting display uses several-mm-class LEDs, a large display such as an indoor/outdoor signage use hundreds-of-pm-class LEDs, and several-µm-class to tens-of-pm-class LEDs may be used for a display.

In the exemplary embodiments of the disclosure, a transfer device and method for a micro-LED chip are illustrated and described.

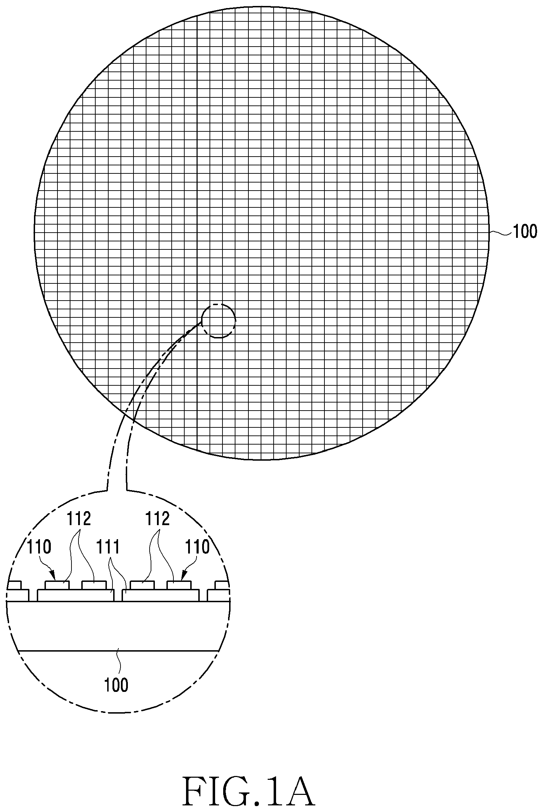

FIG. 1A is a view illustrating the configuration of a base board for manufacturing micro-LED chips in a pad-up state according to various embodiments of the disclosure. FIG. 1A is a view illustrating the configuration of a base board for manufacturing micro-LED chips in a pad-down state according to various embodiments of the disclosure.

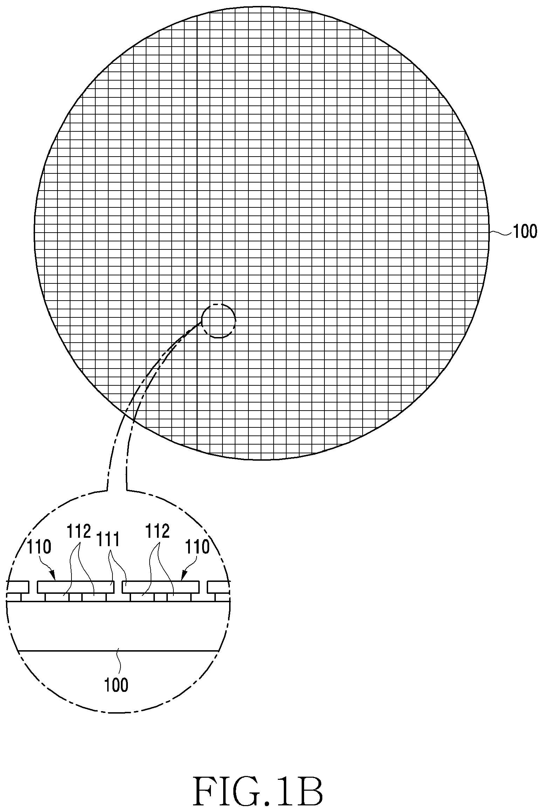

Referring to FIGS. 1A and 1B, a micro-LED chip 110 may have a size of several tens of µm (e.g., 30 to 40 µm) so as to be applied to a sub-pixel constituting a pixel of a near-field display. A plurality of micro-LEDs 110 may be grown in a single crystal state of a compound semiconductor in a high-temperature/high-pressure state on a sapphire-, GaAs-, or SiX-based base board 100 (e.g., a wafer), and colors (e.g., red, green, and blue) may be configured differently depending on respective compositions. For example, red is composed of a GaAs compound semiconductor, green is composed of an InGaP compound semiconductor, and blue is composed of a GaN compound semiconductor. Wavelengths are determined depending on intrinsic energy bandgap values of respective compositions, and thus colors to be implemented are different from each other.

According to an embodiment, in order for a grown micro-LED 110 to emit light, a semiconductor process having several tens of steps may be performed to obtain an electrically connectable structure, which is capable of supplying holes and electrons. In this case, a pair of connection pads 112 disposed to protrude from a micro-LED 110 may be fabricated in a form facing upward (pad-up) (see FIG. 1A) or a form facing downward (pad-down) (see FIG. 1B) with respect to a base board 100.

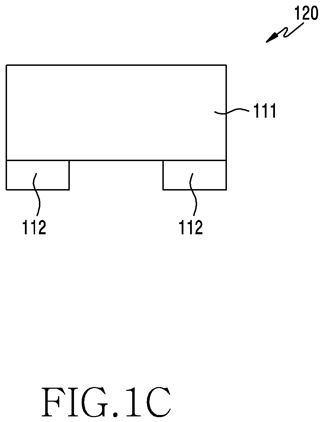

FIG. 1C is a view illustrating a configuration of a micro-LED chip according to various embodiments of the disclosure.

Referring to FIG. 1C, each micro-LED obtained after cutting micro-LEDs may be referred to as a micro-LED chip. Each micro-LED chip 120 includes a body 111 as a light-emitting portion and a pair of connection pads 112 protruding from the body 111 at a predetermined interval. According to an embodiment, the micro-LED chip 110 may be electrically connected to a board (PCB) of an electronic device (e.g., a display) using a conveyance device according to the disclosure to be described later. Hereinafter, the connection pads 112 of the micro-LED chip 120 will be referred to as second electrodes.

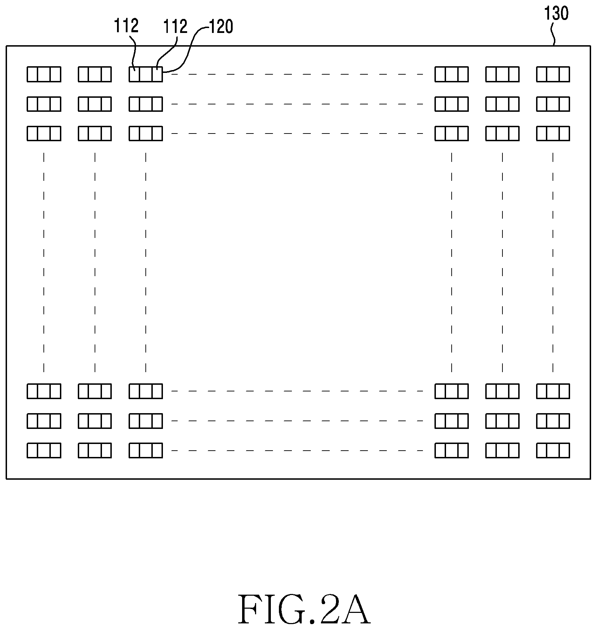

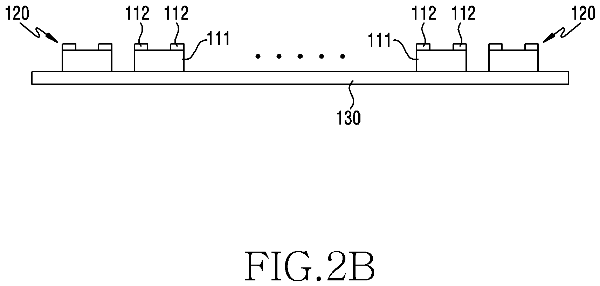

FIG. 2A is a plan view illustrating the state in which micro-LED chips are attached to a transparent board according to embodiments of the disclosure, and FIG. 2B is a side view illustrating the state in which micro-LED chips are attached to a transparent board according to embodiments of the disclosure.

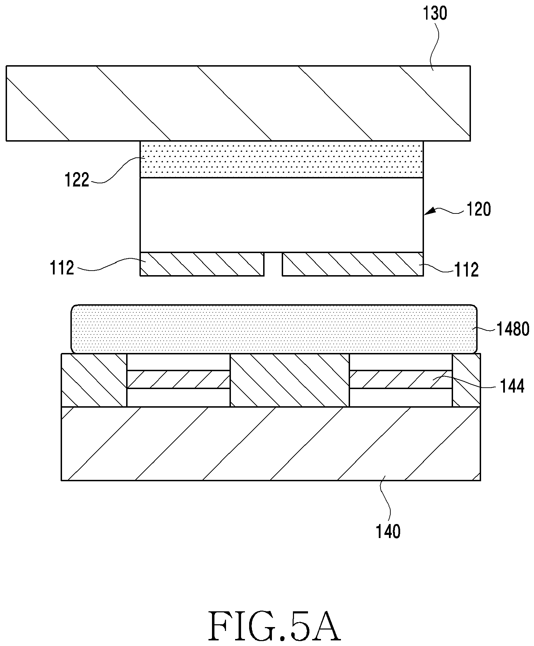

Referring to FIGS. 2A and 2B, a plurality of micro-LED chips 120 is attached in an aligned state on a temporary board by an arrangement device (not illustrated). Each micro-LED chip 120 is maintained in the state of being attached to one surface of the temporary board. An adhesive, for example, an adhesive layer (e.g., the adhesive layer 122 in FIG. 5A), is formed between the micro-LED chip 120 and the temporary board.

According to the embodiments, a temporary board 130 (hereinafter, referred to as a second board) is a transparent board, and may be transparent glass including any one of sapphire, alumina, silica, and quartz materials having high transmittance of light in the ultraviolet wavelength band. The micro-LED chip 120 is provided in the state of being attached to the second board 130 by an adhesive material such as a polyimide, epoxy, or acrylic material.

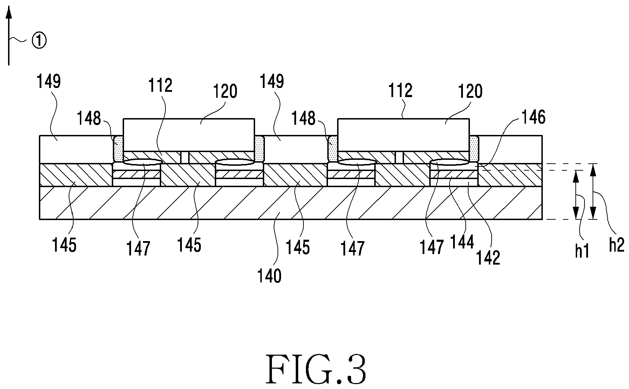

FIG. 3 is a cross-sectional view illustrating the structure of a micro-LED display according to various embodiments of the disclosure.

A structure of a micro-LED display (hereinafter, referred to as a display) according to various embodiments of the disclosure will be described with reference to FIG. 3.

According to various embodiments, the display may include a circuit board 140, a first electrode 144, a micro-LED chip 120, a second electrode 112, a bonding structure, and a composite resin part 148.

According to various embodiments, the circuit board 140 may be a multilayer printed circuit board 140, and may be formed of any one of ceramic, glass, and polymer materials. The circuit board may include a wiring layer 142 and first electrodes 144. The circuit board 140 may include a first surface oriented in a first direction and a second surface oriented in a second direction opposite the first direction. One or more wiring layers 142 may be formed on the first surface. The wiring layers 142 may be signal transmission paths. For example, respective wiring layers 142 may be separated from each other by an insulating layer 145. The wiring layers 142 may be made of a conductive material.

According to the embodiments, the circuit board 140 includes one or more first electrodes 144 formed on one surface of the wiring layer 142. The first electrodes 144 may be formed on a surface of the wiring layer 142 oriented in the first direction, and may be configured in pairs. Respective first electrodes 144 may be separated from each other by an insulating layer 145. For example, each first electrode 144 may be formed in a layer shape. The first electrodes 144 may include a conductive material.

In various embodiments, each first electrode 144 may have a surface layer 146 formed on the first surface oriented in the first direction. The surface layer 146 may be a bonding layer that is processed by a laser and bonded to a second electrode 112 of a micro-LED chip 120. For example, at least a portion of the surface layer 146 may be bonded to at least a portion of the second electrode 112 so as to produce a thermally reactive layer 147. The thermally reactive layer 147 may be a portion of a bonding structure electrically connecting first and second electrodes 144 and 112.

According to various embodiments, the thermally reactive layer 147 may be a connection portion electrically connecting first and second electrodes 144 and 112. The thermally reactive layer 147 may produce a bonding structure by being produced and then melted through laser treatment.

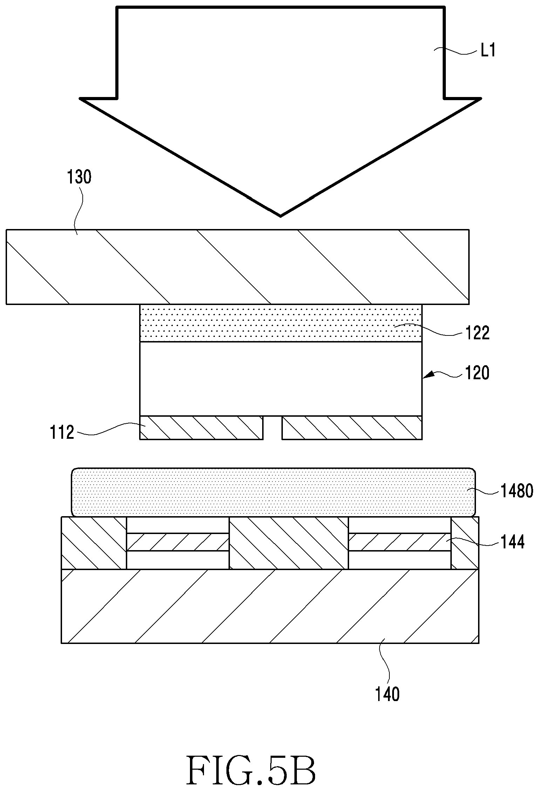

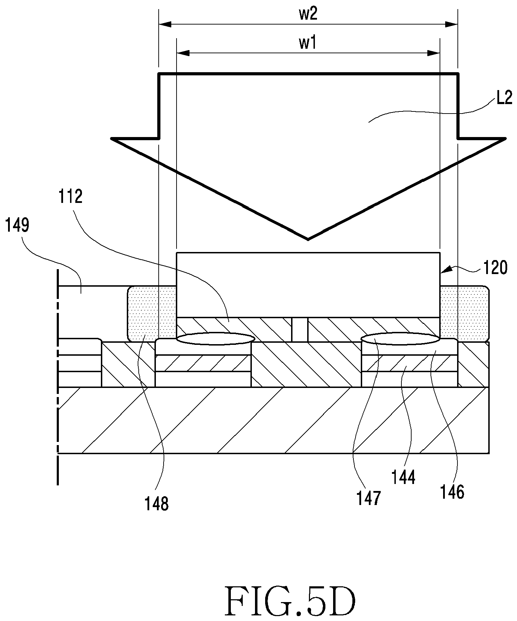

According to the embodiments, the micro-LED chip 120 is arranged on the circuit board 140 in the state of being attached to the second board (e.g., the second board 130 in FIG. 2A) by an adhesive material (e.g., the adhesive material 122 in FIG. 5A), and is then bonded to the circuit board 140 by lasers (e.g., a first laser L1 in FIG. 5B and a second laser L2 in FIG. 5D).

The first and second electrodes 140 and 112 are heated by a laser (e.g., the second laser L2 in FIG. 5D) to produce a bonding structure, such as a thermally reactive layer 147, so that the micro-LED chip 120 can be electrically connected to the wiring layer 142 of the circuit board 140.

According to various embodiments, a composite resin part 148 may be agglomerated and cured after being heated by a laser, and may thus be formed in a shape surrounding each micro-LED chip 120. The composite resin parts 148 may support respective bonding structures, and each composite resin part 148 may be disposed between a micro-LED chip 120 and the circuit board 140, so that the composite resin part 148 is capable of supporting the bonded micro-LED chips 120 on the circuit board 140.

According to various embodiments, the composite resin parts 148 may be disposed on the circuit board 140 at intervals, for example, at equal intervals. Since the micro-LED chips 120 are disposed on the circuit board 140 at equal intervals, the composite resin parts 148 may also be disposed on the circuit board 140 at equal intervals. For example, each composite resin parts 1480 may close a second electrode 112 of a bonding structure from the outside. Accordingly, each composite resin part 1480 may be a protective structure having a bonding structure.

In the display according to various embodiments, the final height h1 of the first electrodes 144 of the circuit board 140 may be lower than or equal to the final height h2 of the insulating layer 145. This structure may help implementing a flat composite resin layer 1480.

Empty spaces 149 may exist between respective composite resin parts 148. The empty spaces 149 may be formed between the micro-LED chips 120, and may be disposed at equal intervals.

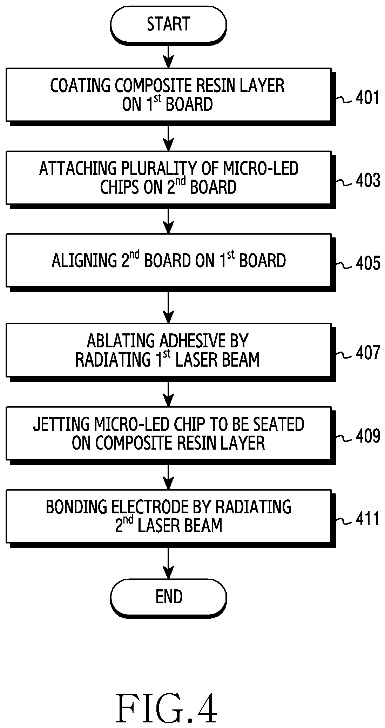

FIG. 4 is a flowchart sequentially illustrating a process of manufacturing a micro-LED display according to the embodiments of the disclosure. FIGS. 5A to 5D are cross-sectional views sequentially illustrating a process of manufacturing a micro-LED display according to the embodiments of the disclosure.

A process of manufacturing a micro-LED display according to the embodiments of the disclosure will be described with reference to FIG. 4 and FIGS. 5A to 5D.

Referring to FIG. 5A, in a display, a composite resin layer 1480 is coated on a circuit board 140 (e.g., operation 401 in FIG. 4). The circuit board 140 may be a board that receives a micro-LED chip 120 in one-to-one correspondence so that the micro-LED chip 120 can be mounted on the circuit board 140. For example, the circuit board 140 may include a TFT board.

According to various embodiments, the composite resin layer may be a layer having a viscosity of a predetermined level or higher, and may be applied to the board. For example, the composite resin layer 1480 may be made of a composite material including, for example, a polymer resin such as epoxy or acrylic and a flux. The composite resin layer 1480 may include a sticky mixture composed of an adhesive material and a flux.

According to various embodiments, the composite resin layer may be made of two or more materials having different boiling points and have the following features: while being coated, the materials have a viscosity between about 500 CPA and about 1500 CPS due to two solvents, and after being coated, the viscosity of the materials increase since the solvent having a lower boiling point is vaporized, and the materials sufficiently absorb an impact applied when the micro-LED chips 120 are jetted and seated. The composite resin layer 1480 may be a damping layer applied on the circuit board 140 to absorb an impact caused by a collision with a jetted micro-LED chip 120, and may be an adhesive layer 122 that causes the micro-LED chip 120 to be fixed at a predetermined position. Due to a damping action, that is, a cushion-like action, and due to an adhesive property, the composite resin layer 1480 is capable of absorbing, from the transparent board, an impact of the micro-LED chip 120 bumping thereinto with acceleration, and is capable of helping the micro-LED chip 120 to be seated on a target first electrode 144 of circuit board 140.

According to various embodiments, the composite resin layer 1480 may have a melting point of about 300 degrees C or lower, and may contain solder particles having a diameter of 0.01 mm or less. When the composite resin layer 1480 is heated, solder is melted and the first electrodes 144 on the circuit board 140 and the second electrodes 122 on the micro-LED chip 120 can be bonded to each other. For example, the solder may include any one or more of tin, silver, copper, indium, zinc, bismuth, and gold.

According to the invention, the micro-LED chip 120 is prepared in the state of being attached to the second board 130 by adhesive 122 (e.g., operation 403 in FIG. 4). After the micro-LED chips 120 are attached to the second board 130, the pads 112 are aligned on the circuit board 140 in a pad-down state (e.g., operation 405 in FIG. 4). In this case, one micro-LED chip 120 may face first electrodes 144 of one circuit board 140 in one-to-one correspondence. Operation 401 may be performed after operation 403.

Referring to FIG. 5B, in the display, the first laser L1 irradiates the micro-LED chip 120 with laser light, preferably from above the top surface of the micro-LED chip 120. Since the board is a transparent material, the laser light that has passed through the board is capable of ablating the adhesive 122 (e.g., operation 407 in FIG. 4). For example, the first laser L1 may include a laser having an ultraviolet wavelength band having excellent optical transmittance or a pulse wave writing device. In addition, the first laser L1 has a wavelength of 400 nm or less and a pulse frequency of 1HZ or less, and one or more micro-LED chips 120 may fall on the composite resin layer 1480 of the circuit board 140 in one shot.

Due to the ablation phenomenon of the adhesive 122, each micro-LED chip 120 falls on the composite resin layer 1480 in the state of having acceleration. This state may be referred to as jetting of the micro-LED 120. In this operation, the laser light from the first laser L1 and the micro-LED chip 120 may proceed simultaneously.

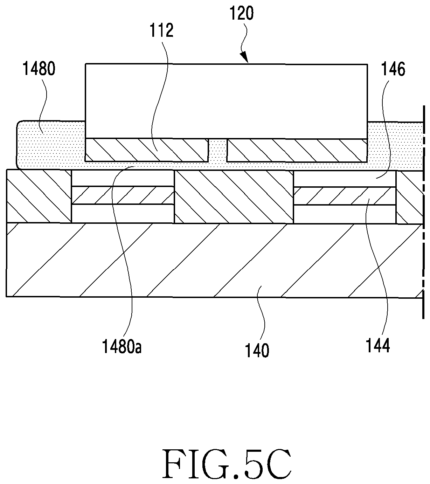

After jetting each micro-LED chip 120, the composite resin layer 1480 absorbs the impact of a micro-LED chip 120 bumping thereinto thanks to the cushioning action and adhesive property thereof, and accordingly, the micro-LED chip 120 is seated on the target electrodes (e.g., operation 409 in FIG. 4). Each micro-LED chip 120 seated on the composite resin layer 1480 is illustrated in FIG. 5C.

Referring to FIG. 5C, the second electrodes 112 of each of the seated micro-LED chips 120 is in the state of facing the first electrodes 144 of the circuit board 140. Between the first electrodes 144 and the second electrodes 112, a portion of a relatively thin composite resin layer 1480a may exist, and a surface layer 146 may exist.

Referring to FIG. 5D, in the display according to various embodiments, a second laser L2 irradiates the LED chip 120 seated on the composite resin layer 1480 with laser light, preferably from above the top surface of the micro-LED chip 120 seated on the composite resin layer 1480. In a heating operation (e.g., to about 120 degrees C or higher) by irradiation of the second laser L2, the first electrodes 144 and the second electrodes 112 are bonded to each other (e.g., operation 411 in FIG. 4). By this heating operation, the composite resin layer undergoes phase decomposition into flux and adhesive. Thus, the flux is capable of improving the wetting property of the bonding portion so as to achieve smooth solder bonding, and the adhesive is coated on the bonding portion so as to protect the bonding portion.

Meanwhile, solder may be included in the composite resin layer 1480, may be included in the surface layer 146, or may be included in both of the composite resin layer 1480 and the surface layer 146.

According to various embodiments, the composite resin layer 1480 may include particles of, for example, a white or black color. Due to the inclusion of these particles, the composite resin layer 1480 may improve optical properties of the display.

When the second laser L2 radiates laser light toward the second electrodes 112, the second electrodes 112 and the surface layer 146 are melted, so that chemical bonding may be achieved. The thermal reactive layer 147 may be produced through such chemical bonding. The thermally reactive layer 147 may be a portion of a bonding structure electrically connecting first and second electrodes 144 and 112. For example, the second laser L2 may be a laser of an infrared wavelength band. The second laser may be configured to radiate laser light having a width equal to or slightly larger than the width of the first electrodes 144. Alternatively, the second laser may be configured to radiate laser light having a width equal to or slightly larger than the width of the second electrodes 112.

In the display, the composite resin layer 1480, which has been present, is agglomerated and cured by irradiation by the second laser L2, and may serve as a support member for supporting the bonding structure between the circuit board 140 and a micro-LED chip 120. The cured composite resin layer 1480 will be referred to as a composite resin part 148. The composite resin part 148 may be formed to surround a micro-LED chip 120 on the circuit board 140. In addition, the composite resin part 148 may be formed to surround a bonding structure. One micro-LED chip 120 may have one composite resin part 148 formed thereon. Respective micro-LED chips 120 may be spaced apart from each other, and an empty space 149 may exist between respective composite resin parts 148

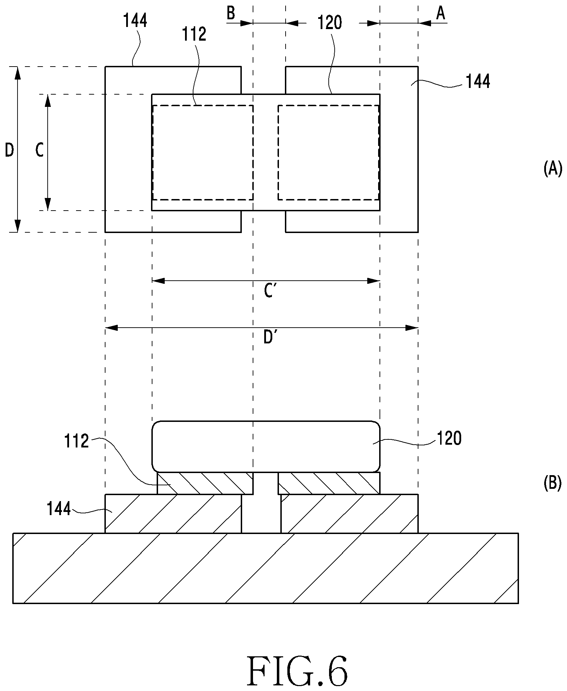

FIG. 6A is a plan view illustrating the state in which a micro-LED chip is connected to first electrodes, and FIG. 6B is a vertical cross-sectional view illustrating the state in which a micro-LED chip is connected to first electrodes.

Referring to FIGS. 6A and 6B, in the display, in order to heat electrodes by partially irradiating the display with laser light or an energy beam, the size of the micro-LED chip (C x C') may be made to be smaller than the size of the first electrodes 144 (D x D').

In the display, in order to prevent a short circuit, a distance B between one end of an first electrode 144 in a place in which the first electrodes face each other and one end of a second end 112 in a place in which the second electrodes face each other may be designed to be smaller than a distance A between the other end of the first electrode 144 and the other end of the second electrode 112 at the other sides.

According to various embodiments, the second electrodes 112 of the micro-LED chip may be formed to be smaller than the size of the first electrodes 144 of the circuit board.

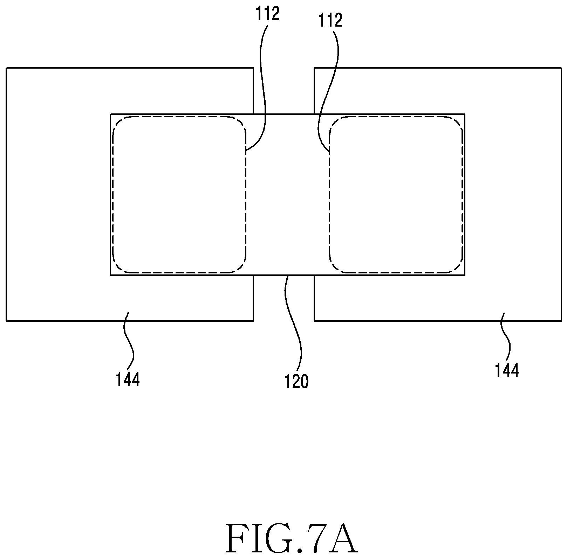

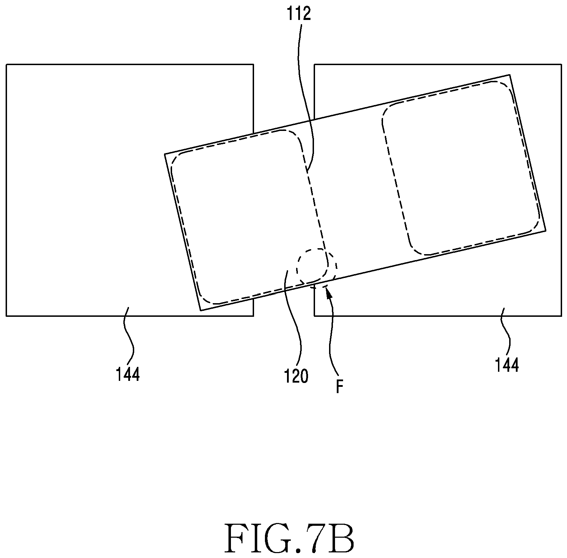

FIG. 7A is a plan view illustrating the state in which a micro-LED chip is connected to first electrodes. FIG. 7B is a plan view illustrating the state in which a micro-LED is incorrectly connected to first electrodes.

FIG. 7A illustrates a case where the second electrodes 112 of each micro-LED chip are aligned on the first electrodes 144 of each circuit board 140 on one-to-one (1:1) correspondence and then correctly seated. In general, the first electrodes 144 or the second electrodes 112 may be formed in a rectangular shape.

However, as illustrated in FIG. 7B, when a second electrode 112 of the micro-LED chip 120 are connected to an electrode on the opposite side, an electrical short portion/an open defect F may occur in an electronic circuit. In order to prevent such a defective connection state, the first electrodes 144 may have various shapes as necessary.

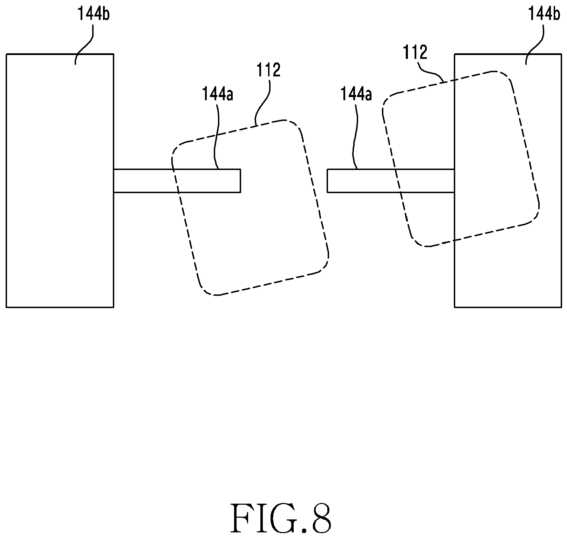

FIG. 8 is a plan view illustrating a shape of first electrodes.

Referring to FIG. 8, in the first electrodes 144, assuming that, with respect to the intermediate portion, portions located near each other are first portions 144a and portions located far from each other are second portions 144b, the area of the first portions 144a may be smaller or narrower than the area of the second portions 144b. For example, the first portions 144a may extend toward each other from the second portions 144b, respectively, and have a rectangular shape that is narrower than the vertical width of the second portions 144b.

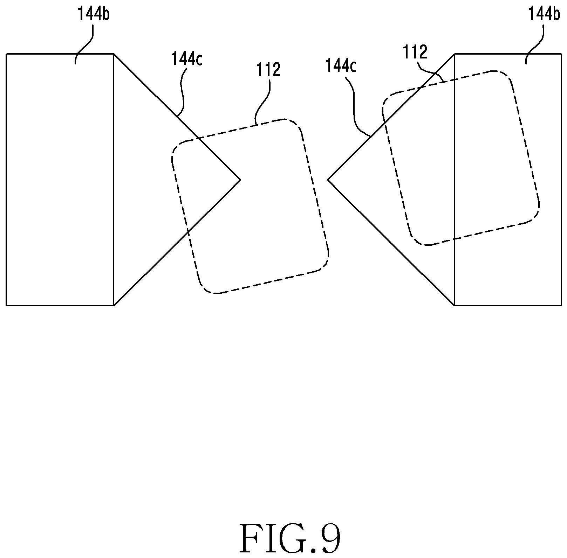

FIG. 9 is a plan view illustrating another shape of first electrodes.

Referring to FIG. 9, in the first electrodes 144, assuming that, with respect to the intermediate portion, portions located near each other are first portions 144c and portions located far from each other are second portions 144d, the area of the first portions 144c may be smaller or narrower than the area of the second portions 144d. For example, each the first portions 144c may be formed in a triangular shape having a bottom side, which corresponds to the vertical width of a corresponding one of the second portions 144d.

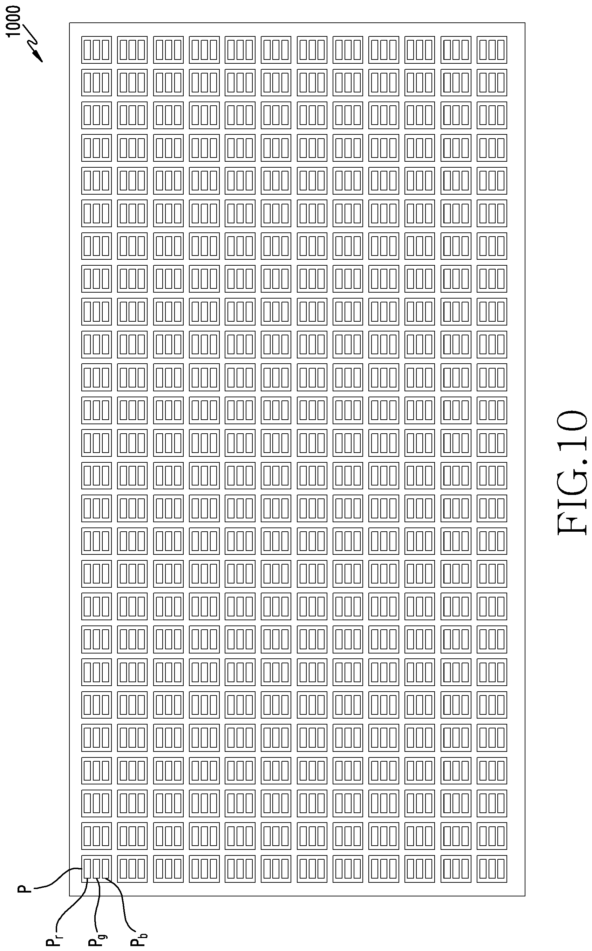

A micro-LED display 1000 manufactured through the manufacturing process illustrated in FIGS. 5A to 5D is illustrated in FIG. 10.

According to an embodiment, in the display 1000, a plurality of pixels P may be disposed at a predetermined interval, and each pixel may include sub-pixels Pr, Pg, and Pb. According to an embodiment, micro-LED chips (e.g., micro-LED chips 120 in FIG. 3) corresponding to respective sub-pixels Pr, Pg, and Pb can be mounted on a circuit board (e.g., the circuit board 140 in FIG. 3A) of the display 100 be quickly and accurately.

Various embodiments disclosed in this specification and the drawings are provided merely to represent specific examples for the purpose of easily describing the technical contents of the disclosure and helping the understanding of the disclosure, and are not intended to limit the scope of the disclosure. Accordingly, the scope of the disclosure should be construed in such a manner that, in addition to the embodiments disclosed herein, all changes or modifications derived from the technical idea of the disclosure are included in the scope of the disclosure. The invention is defined by the appended claims.

## Claims

1. A method of manufacturing a micro-LED display, the method comprising the following successive steps:
a first step (401) for forming a composite resin layer (1480) on a circuit board (140);
a second step (405) for aligning a transparent board (130) to which a plurality of micro-LED chips (120) are attached (403) via adhesive (122) on the first circuit board (140);
a third step (407) of ablating the adhesive (122) by irradiating each of the micro-LED chips (120) with at least one first laser beam (L1);
a fourth step (409) of jetting the micro-LED chips (120) to be seated on the composite resin layer (1480);
a fifth step of irradiating electrodes (112) of the seated micro-LED chips (120) with at least one second laser beam (L2); and
a sixth step (411) of bonding electrodes (144) of the circuit board (140) and the electrodes (112) of the micro LED chips (120) by means of said irradiating with the at least one second laser beam (L2).

2. The method of claim 1, wherein after the sixth step (411), the composite resin layer (1480) is cured and encloses a bonded state of the micro-LED chips (120).

3. The method of claim 1, wherein the electrodes (112) of the micro-LED chips (120) have a size smaller than a size of the electrodes (144) of the board (140).

4. The method of claim 1, wherein the composite resin layer (1480) is uniformly coated on the electrodes (144) of the circuit board (140) to a thickness of 0.015 mm or less.

5. The method of claim 1, wherein the composite resin layer (1480) acts as a damping layer that absorbs an impact of jetted micro LED chips (120), and is made of a material having an adhesive property to cause the seated micro LED chips (120) to be attached thereto.

6. The method of claim 1, wherein the composite resin layer (1480) is composed of two or more solvent materials having different boiling points, wherein in the first step, the composite resin layer (1480) has a viscosity of 1,000 CPS or less by two solvents, and after the first step, a solvent having a lower boiling point is evaporated and the viscosity increases.

7. The method of claim 1, wherein the composite resin layer (1480) contains solder particles having a melting point of 300 degrees C or lower and having a diameter of 0.01 mm or less, and during the sixth step, the solder is melted so that the electrodes (144) of the circuit board (140) and the electrodes (112) of the micro-LED display are bonded to each other.

8. The method of claim 1, wherein the composite resin layer (1480) contains white or black particles.

9. The method of claim 1, wherein, in the second step, the electrodes (112) of each of the micro LED chips (120) are aligned in a state of facing the electrodes (144) of the circuit board (140) in one-to-one correspondence.

## Patentansprüche

1. Verfahren zur Herstellung einer Mikro-LED-Anzeige, wobei das Verfahren die folgenden aufeinanderfolgenden Schritte umfasst:
einen ersten Schritt (401) zum Bilden einer Verbundharzschicht (1480) auf einer Leiterplatte (140);
einen zweiten Schritt (405) zum Ausrichten einer transparenten Platte (130), an der eine Vielzahl von Mikro-LED-Chips (120) mittels Klebstoff (122) befestigt (403) sind, auf der ersten Leiterplatte (140);
einen dritten Schritt (407) zum Abtragen des Klebstoffs (122) durch Bestrahlen jedes der Mikro-LED-Chips (120) mit mindestens einem ersten Laserstrahl (L1);
einen vierten Schritt (409) zum Ausstoßen der Mikro-LED-Chips (120), die auf der Verbundharzschicht (1480) eingesetzt werden sollen;
einen fünften Schritt zum Bestrahlen von Elektroden (112) der eingesetzten Mikro-LED-Chips (120) mit mindestens einem zweiten Laserstrahl (L2); und
einen sechsten Schritt (411) zum Verbinden von Elektroden (144) der Leiterplatte (140) und der Elektroden (112) der Mikro-LED-Chips (120) mittels Bestrahlen mit dem mindestens einen zweiten Laserstrahl (L2).

2. Verfahren nach Anspruch 1, wobei nach dem sechsten Schritt (411) die Verbundharzschicht (1480) ausgehärtet wird und einen verbundenen Zustand der Mikro-LED-Chips (120) umschließt.

3. Verfahren nach Anspruch 1, wobei die Elektroden (112) der Mikro-LED-Chips (120) eine Größe aufweisen, die kleiner ist als eine Größe der Elektroden (144) der Platte (140).

4. Verfahren nach Anspruch 1, wobei die Verbundharzschicht (1480) auf die Elektroden (144) der Leiterplatte (140) bis zu einer Dicke von 0,015 mm oder weniger gleichmäßig aufgetragen wird.

5. Verfahren nach Anspruch 1, wobei die Verbundharzschicht (1480) als eine Dämpfungsschicht wirkt, die einen Aufprall von ausgestoßenen Mikro-LED-Chips (120) absorbiert, und aus einem Material hergestellt ist, das eine Klebeeigenschaft aufweist, die bewirkt, dass die eingesetzten Mikro-LED-Chips (120) daran befestigt werden.

6. Verfahren nach Anspruch 1, wobei die Verbundharzschicht (1480) aus zwei oder mehr Lösungsmittelmaterialien mit unterschiedlichen Siedepunkten zusammengesetzt ist, wobei im ersten Schritt die Verbundharzschicht (1480) eine Viskosität von 1.000 cP oder weniger durch zwei Lösungsmittel aufweist, und nach dem ersten Schritt ein Lösungsmittel mit niedrigerem Siedepunkt verdampft wird und die Viskosität ansteigt.

7. Verfahren nach Anspruch 1, wobei die Verbundharzschicht (1480) Lotpartikel mit einem Schmelzpunkt von 300 Grad Celsius oder weniger und mit einem Durchmesser von 0,01 mm oder weniger enthält, und während des sechsten Schritts das Lot geschmolzen wird, so dass die Elektroden (144) der Leiterplatte (140) und die Elektroden (112) der Mikro-LED-Anzeige miteinander verbunden werden.

8. Verfahren nach Anspruch 1, wobei die Verbundharzschicht (1480) weiße oder schwarze Partikel enthält.

9. Verfahren nach Anspruch 1, wobei im zweiten Schritt die Elektroden (112) jedes der Mikro-LED-Chips (120) in einem Zustand ausgerichtet werden, in dem sie den Elektroden (144) der Leiterplatte (140) in einer Eins-zu-eins-Entsprechung gegenüberliegen.

## Revendications

1. Procédé de fabrication d'un écran micro-LED, le procédé comprenant les étapes successives suivantes :
une première étape (401) de formation d'une couche de résine composite (1480) sur une carte de circuit imprimé (140) ;
une deuxième étape (405) d'alignement d'une carte transparente (130), sur laquelle une pluralité de puces micro-LED (120) sont fixées (403) par un adhésif (122), sur la première carte de circuit imprimé (140) ;
une troisième étape (407) d'ablation de l'adhésif (122) par irradiation de chacune des puces micro-LED (120) par au moins un premier faisceau laser (L1) ;
une quatrième étape (409) de jet des puces micro-LED (120) à placer sur la couche de résine composite (1480) ;
une cinquième étape d'irradiation des électrodes (112) des puces micro-LED (120) placées, par au moins un deuxième faisceau laser (L2) ; et
une sixième étape (411) de liaison des électrodes (144) de la carte de circuit imprimé (140) et des électrodes (112) des puces micro-LED (120) au moyen de ladite irradiation par l'au moins un deuxième faisceau laser (L2).

2. Procédé selon la revendication 1, dans lequel après la sixième étape (411), la couche de résine composite (1480) subit un durcissement et renferme un état lié des puces micro-LED (120).

3. Procédé selon la revendication 1, dans lequel les électrodes (112) des puces micro-LED (120) ont une taille inférieure à celle des électrodes (144) de la carte (140).

4. Procédé selon la revendication 1, dans lequel la couche de résine composite (1480) est enduite uniformément sur les électrodes (144) de la carte de circuit imprimé (140) à une épaisseur de 0,015 mm ou moins.

5. Procédé selon la revendication 1, dans lequel la couche de résine composite (1480) agit en couche amortissante qui absorbe l'impact des puces micro-LED (120) jetées, et est constituée d'un matériau doté d'une propriété adhésive qui amène les puces micro-LED (120) placées à s'y fixer.

6. Procédé selon la revendication 1, dans lequel la couche de résine composite (1480) se compose d'au moins deux matières solvantes présentant des points d'ébullition différents, ladite couche de résine composite (1480) ayant, dans la première étape, une viscosité de 1 000 cP ou moins du fait de la présence de deux solvants, et après la première étape, un solvant ayant un point d'ébullition inférieur est évaporé, ce qui fait augmenter la viscosité.

7. Procédé selon la revendication 1, dans lequel la couche de résine composite (1480) contient des particules de brasure présentant un point de fusion de 300 degrés Celsius ou moins et présentant un diamètre de 0,01 mm ou moins, et pendant la sixième étape, la brasure est amenée à fondre de telle manière que les électrodes (144) de la carte de circuit imprimé (140) et les électrodes (112) de l'écran micro-LED sont liées entre elles.

8. Procédé selon la revendication 1, dans lequel la couche de résine composite (1480) contient des particules blanches ou noires.

9. Procédé selon la revendication 1, dans lequel, dans la deuxième étape, les électrodes (112) de chacune des puces micro-LED (120) sont alignées en étant face aux électrodes (144) de la carte de circuit imprimé (140) en correspondance une-à-une.
